(19) Europäisches Patentamt
European Patent Office
Office européen des brevets

(11) **EP 3 118 458 B1**

(12) **EUROPEAN PATENT SPECIFICATION**

(45) Date of publication and mention
of the grant of the patent:
**30.08.2017 Bulletin 2017/35**

(51) Int Cl.:
*F04C 28/08* (2006.01)    *F04C 18/16* (2006.01)
*F04C 28/28* (2006.01)    *F04C 29/00* (2006.01)
*G01R 21/133* (2006.01)

(21) Application number: **15176847.0**

(22) Date of filing: **15.07.2015**

(54) **METHOD AND APPARATUS IN CONNECTION WITH A SCREW COMPRESSOR**

VERFAHREN UND VORRICHTUNG IN VERBINDUNG MIT EINEM SCHRAUBENVERDICHTER

PROCÉDÉ ET APPAREIL EN RELATION AVEC UN COMPRESSEUR À VIS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.01.2017 Bulletin 2017/03**

(73) Proprietor: **ABB Technology Oy
00380 Helsinki (FI)**

(72) Inventors:
• **Kosonen, Antti
53850 Lappeenranta (FI)**
• **Ahola, Jero
53850 Lappeenranta (FI)**

(74) Representative: **Kolster Oy Ab
Salmisaarenaukio 1
00180 Helsinki (FI)**

(56) References cited:
WO-A1-2005/038257    JP-A- 2008 185 039
US-A1- 2008 038 127

## Description

FIELD OF THE INVENTION

The present invention relates to screw compressors, and particularly to screw compressors driven with a frequency converter.

BACKGROUND OF THE INVENTION

Screw compressors are widely used compressor types for producing pressurized gas for multiple of purposes. One of the uses of screw compressors is in pressurised air systems for generating pressurised air to a vessel or similar pressure tank from which the pressurised air is used through hoses or pipes, for example. In such a system, the screw compressor is operated to provide a desired pressure to the vessel and keep the vessel pressurized during the use of the pressurized air.

Screw compressors are rotated by an electric motor for generating the pressure. Document WO2005/038257 relates to a speed-regulated helical screw rotor compressor that is adapted to work against a pressure container whose pressure P lies within the working range of the compressor and which is allowed to vary between a lowest pressure and a highest pressure. The compressor is driven by an electric motor. Further, frequency converters are often employed to drive the electric motor in a controlled and efficient manner. In order to control the system efficiently with a frequency converter the system should be identified with respect to its different operation points and characteristic power consumption in these operation points.

The power consumptions in different operation points can be gathered by excessive test procedures in which consumption data is gathered in each of the operation points. However, such operation takes a long time. Further, the properties of the screw compressor system may change, and therefore the procedures for determining the most efficient operation points should be repeated regularly to obtain reliable results.

BRIEF DESCRIPTION OF THE INVENTION

An object of the present invention is to provide a method and an apparatus for implementing the method so as to solve the above problem. The objects of the invention are achieved by a method and an apparatus which are characterized by what is stated in the independent claims. The preferred embodiments of the invention are disclosed in the dependent claims.

The invention is based on the idea of filling the pressure vessel of the screw compressor system in such a manner that during the filling or pressurizing the vessel the efficiency or power consumption of the system can be determined in desired operating points. Further, an energy consumption map may be generated on the basis of a single filling of the vessel. Such map may be used for determining the optimal rotation speed reference for the frequency converter depending on the pressure of the vessel.

An advantage of the invention is that already after the filling of the pressure vessel the optimal rotation speeds can be determined without any external measurement instruments using only the internal measurements of the frequency converter.

BRIEF DESCRIPTION OF THE DRAWINGS

In the following the invention will be described in greater detail by means of preferred embodiments with reference to the attached drawings, in which

Figure 1 shows a speed profile used in an embodiment of the invention;
Figure 2 shows mass flow profile obtained with speed profile of Figure 1;
Figure 3 shows pressure ratio as a function of rotational speed obtained with the speed profile of Figure 1;
Figure 4 shows plots of energy consumption as a function of pressure ratio;
Figure 5 shows plots of energy consumption as a function rotational speed; and
Figure 6 shows path of optimal rotation speed as a function of pressure ratio.

DETAILED DESCRIPTION OF THE INVENTION

In the present invention a screw compressor drive, comprising a screw compressor and a frequency converter, is driven with a frequency converter. As known, a frequency converter can drive an electric motor with a variable rotation speed. In the system associated with the invention, the output of a frequency converter is connected to an electric motor, which rotates the screw compressor for producing pressurized gas.

Frequency converters include typically processors having calculation capacity and internal measurements. The measurements relate, for example, to rotational speed, torque and power. These measurements can be used in the processor of the device for further calculations.

In the present invention, a pressure vessel of a screw compressor driven with a frequency converter is filled or pressurised. According to an embodiment of the invention, the pressurising is carried out using a specific speed profile in which speed is changed in a timed manner. In the speed profile the speed is changed stepwise and kept substantially constant for a time interval. The same speed profile is repeated until the pressure vessel of the system is pressurized to a set level. The speed profile is kept constant for a specified time interval so that the system stabilizes for accurate measurements. A suitable value for the constant speed operation is in the range of 5 to 25 seconds depending on the properties of the system. The mentioned properties include possible time delays in measurement and the settling time of the system.

According to an embodiment of the invention, the speed profile is repeated at least three times during the filling of the pressure vessel. The repeating of the speed profile is carried out with substantially same changes in rotational speed and keeping the rotational speed substantially constant at the same levels each time the profile is repeated.

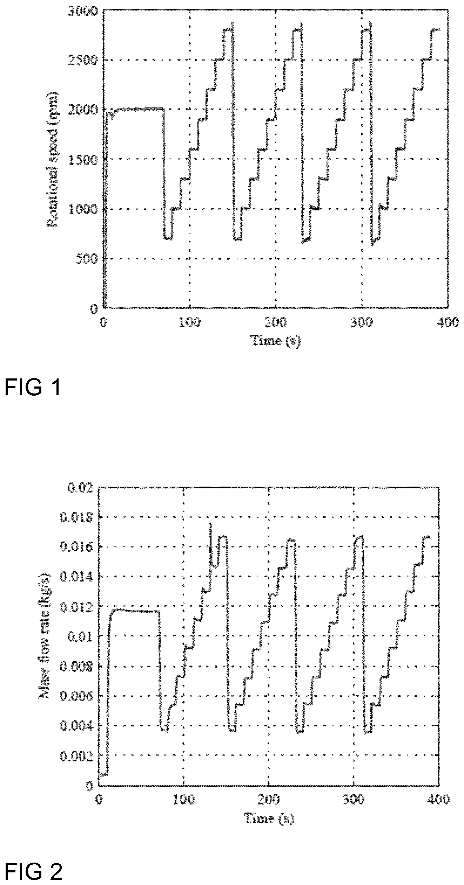

Figure 1 shows an example of a speed profile used in an embodiment. First, the speed is increased to 2000rpm for building initial pressure to the pressure vessel. The speed is then decreased to approximately 700rpm and from which the stepwise changes are started at approximate time instant 800s. In the example of Figure 1, the speed is increased with steps of 300rpm and kept substantially constant for a period of 10 seconds.

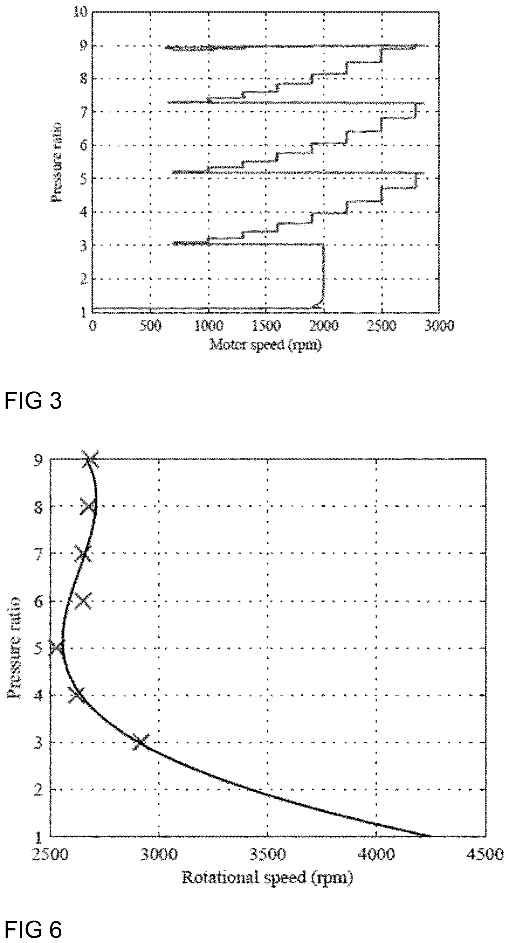

Figure 2 shows the mass flow rate obtained with the speed profile of Figure 1 and Figure 3 shows pressure ratio of the vessel as a function of motor speed obtained with the speed profile of Figure 1. The pressure ratio is the ratio of pressure of the vessel and of the ambient. When the ambient pressure is at a normal level, then the pressure ratio corresponds directly to the pressure of the vessel (i.e. ambient pressure is one bar). From Figure 2 it can be seen, that the mass flow rate is linear with respect to rotational speed in a screw compressor. Thus when the mass flow rate of a single rotational speed of the screw compressor is known, the mass flow rates of any rotational speed can be directly calculated. Typically a mass flow rate with nominal rotational speed is known.

It is seen from Figure 3 that the stepwise changes of the rotational speed cause a stepwise change in the pressure. Further, when the speed profile is repeated, the vessel is pressurised with the same rotational speeds with different pressures.

According to the invention, the power consumption of the screw compressor system is determined during the pressurising of the pressure vessel. Preferably the power consumption of the whole system is determined so as to find the optimal rotational speed as a function of the pressure of the vessel. The output power of the frequency converter can be calculated on the basis of the output voltage and output current of the frequency converter in a known manner, both of which are known readily at the frequency converter. Therefore, the output power of the frequency converter $P_{fc,output}$ can be calculated in the known manner as a product between the output current and output voltage taking also into account the power factor. The losses of the frequency converter $P_{fc,loss}$ can be estimated using an equation

$$P_{fc,loss} = \left( 0,35 + 0,1\frac{f}{f_n} + 0,55\frac{T}{T_n} \right) P_{fc,loss,nom}$$

in which f is the output frequency of the frequency converter, $f_n$ is the nominal frequency of the frequency converter, T is the motor torque, $T_n$ is the nominal motor torque, and $P_{fc,loss,nom}$ is the losses of the frequency converter in the nominal point. The torque is readily available in the control system of the frequency converter similarly as the rotational speed.

The input power $P_{in}$ to the frequency converter can be calculated as a sum of the losses of the frequency converter and output power of the frequency converter.

The equation given above is an example of a possible approximation of the losses of the frequency converter. The losses can be calculated or determined using other possible procedures. It is even possible to directly measure the input power to the frequency converter using the internal measurements of a frequency converter.

The input power or power consumption is determined each time after the stepwise change in the speed profile. The pressure of the screw compressor is also known in the frequency converter. The frequency converter may even be pressure controlled such that the speed profile is obtained by changing pressure reference to the system.

It can be seen from the example of Figure 3 that when operated according to the invention, the screw compressor operates at least three different pressure ratios with the same rotational speed. This means that with the same rotational speed at least three energy consumption values are obtained relating to different pressure ratios. As mentioned, the rotational speed is changed in the procedure, and therefore power consumption measurements are obtained with multiple rotational speeds each with a multiple of pressure ratios. If the pressure ratio varies slightly during constant speed operation of the frequency converter, then an average value of the pressure ratios can be calculated during the constant speed operation. The average value of the pressure ratio is then used as representing the pressure ratio in that constant speed operation. Similarly, if the power consumption varies during the constant speed operation, an average of the power consumption may be calculated and used as a value representing power consumption.

The determined power consumption as such does not indicate the efficiency relating to operation of the compressor. The energy efficiency of the compressor drive can be calculated as

$$E_s = \frac{P_{in}}{q_m \cdot 3600},$$

in which $P_{in}$ is the input power to the compressor drive (i.e. input power of the frequency converter) and $q_m$ is the mass flow rate (kg/s). The above equation tells how much energy has to be consumed to get mass flow rate of pressurised air and the obtained unit of efficiency is kWh/kg.

The obtained energy consumption data is stored and used for calculating efficiency or energy consumption in one or more operating points. One possibility of using the gathered data is to build an optimal rotational speed curve as a function of a pressure ratio. From such a curve the optimal rotational speed of the frequency converter can be read depending on the pressure ratio. One possible way of forming such a curve is presented below.

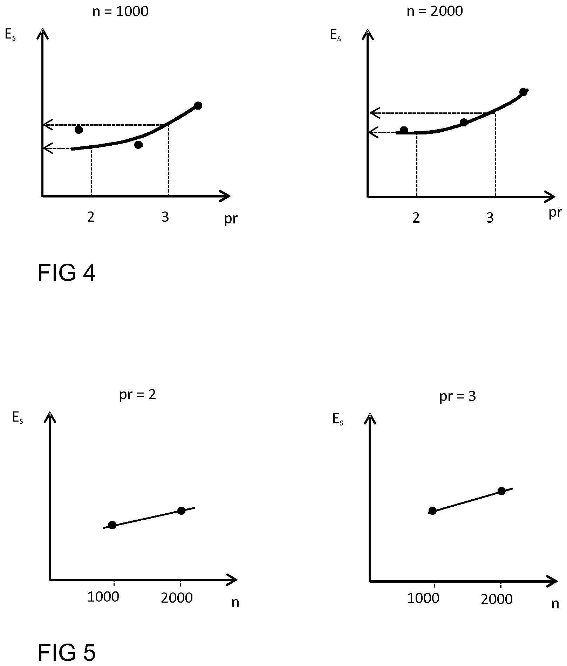

On the basis of Figure 3 and the calculated energy consumption, the energy efficiency $E_s$ can be plotted as a function of pressure ratio pr with fixed rotational speeds n. That is, for rotational speeds in which the power consumption was measured, the energy efficiency is plotted as a function of pressure ratio. Examples of such plots are shown in Figure 4 for rotational speeds of n=1000 and n=2000.

The specific samples in the plots of Figure 4 are shown as dots. Further, on the basis of the sample values, a second order polynomial fitting curve formed and it is presented also in Figure 4. The fitting curve approximates the behaviour of the energy consumption when the pressure ratio changes. In other words, at least second order polynomial fitting curves for pressure ratio and specific energy consumption for the selected rotational speeds are defined.

Next the power consumption is plotted as a function of rotational speed with constant pressure ratios pr. That is to say that for different pressure ratios the energy consumption is plotted as a function of rotational speed of the motor. Examples of such plots are shown in Figure 5 for pressure ratios 2 and 3. The values (dots) of energy efficiency in Figure 5 for specific pressure ratios are read from the curves of Figure 4, i.e. for plot of pressure ratio = 2, a value with a pressure ratio of 2, is read from the chart n= 1000 and from the chart n=2000. Thus a vector for pressure ratios is formed, and at least second order polynomial fitting curves are calculated for rotational speed and specific energy consumption or efficiency for fixed pressure ratios.

Figure 5 further shows a second polynomial fitting made to the presented values. In Figures 5 only two data points are shown and the fitting curve is a straight line. However, with more data points a second order curve fitting produces a curve that approximates the change of energy efficiency with rotational speed.

From the values presented in plots of Figure 5 and from the fitting curve, the optimal rotational speed of the motor can be read when the pressure ratio is known. The plots of Figure 5 can be combined in a matrix to present the energy efficiencies as a function of rotational speed and pressure ratio. The rotation speeds can be selected from the curves and they do not have to be the same as used in the initial measurement. Further, the lowest energy consumptions, i.e. best efficiencies with different pressure rations can be collected to a single chart which presents optimal rotational speed curves as a function of pressure ratio. Such values are presented in Figure 6 with a polynomial fitting. When such a curve is followed based on the pressure ratio, the energy consumption of the system is minimized.

In the above, the gathered data is utilized in different plots. The plots and drawings are used only to visualize the procedure that may be followed to obtain optimum operation points. It is clear that the calculations, such as curve fittings, are done without need for plotting the information.

Further, when the optimum operating rotational speed is needed only in few pressure ratios, the calculation may be simplified from the above described procedure. The curve fittings presented in the above example can also be replaced with another approximation. Such another approximation can be, for example, simple interpolation between two consecutive measurement points or higher order polynomial fittings.

The examples of Figures 4 and 5 show limited number of data points. It is however clear that when the energy efficiency is determined throughout the rotational speed range as illustrated in Figures 1 to 3, more data points are gathered.

When the procedure according to the invention is repeated, possible wear or malfunction of the system can be detected if the optimum points deviate from each other. That is, if the repeated measurement gives results that show changes in the optimum frequency with one or multiple of pressure ratios, it can be concluded that some properties of the system has changed. For example, oilfree compressor systems are prone to mechanical wear, and this wear can be detected by monitoring the changes in the optimum operating points.

The invention may be implemented into existing systems. Existing devices comprise a processor and a memory that may be utilized to implement the functionality of the embodiments of the invention. Hence all changes and configurations needed for implementing the embodiments of the invention, may be performed by software routines, which in turn may be implemented as added or updated software routines. If the functionality of the invention is implemented by software, the software may be provided as a computer program product comprising a computer program code which, when run on a computer, causes the computer, or similar equipment, to perform the functionality of the invention as described above. The computer program code may be stored on a computer readable medium, such as a suitable memory means, e.g. a flash memory or on a disc memory, from which it is readable to the unit or units executing the program code. In addition, the program code may be loaded to the unit or units executing the program code through a suitable data network and it may replace or update a possibly existing program code.

It will be obvious to a person skilled in the art that, as the technology advances, the inventive concept can be implemented in various ways. The invention and its embodiments are not limited to the examples described above but may vary within the scope of the claims.

## Claims

1. A method of determining operation characteristics of a screw compressor drive comprising a screw compressor driven with a frequency converter, wherein the method comprises

    pressurising a pressure vessel of the screw compressor with a variable rotational speed of the screw compressor, the rotational speed of the screw compressor having a speed profile in which the rotational speed is changed stepwise such that between stepwise changes the rotational speed of the screw compressor is kept substantially constant for a time period,

    repeating the speed profile until the pressure of the pressure vessel reaches a set pressure value,

    determining pressure of the pressure vessel, power consumption of the screw compressor drive and mass flow rate during the pressurising when the rotational speed of the screw compressor is kept substantially constant,

    calculating energy efficiency of the screw compressor drive as a function of pressure of the pressure vessel and rotational speed of the screw compressor on the basis of the determined pressure of the pressure vessel and power consumption of the screw compressor drive.

2. Method according to claim 1, wherein the method comprises

    selecting optimal rotational speed for the frequency converter as a function of pressure of the pressure vessel.

3. Method according to claim 1 or claim 2, wherein the calculating energy efficiency comprises

    selecting multiple of rotational speeds,

    calculating at least a second order polynomial fitting curves for pressure ratio and energy efficiency for selected rotational speeds,

    selecting multiple of pressure ratios,

    calculating at least a second order polynomial fitting curves for rotational speed and energy efficiency for selected pressure ratios, and

    for each of the selected pressure ratios, determining a rotational speed having the best energy efficiency from the calculated polynomial fitting curves for rotational speed and energy efficiency.

4. Method according to claim 3, wherein after determining the rotational speed having the best energy efficiency, the rotational speed used in control of the frequency converter is selected based on the pressure ratio.

5. Method according to any one of the previous claims 1 to 4, wherein the power consumption of the screw compressor drive is estimated based on output power of the frequency converter and internal losses of the frequency converter.

6. Method according to any one of the previous claims 1 to 5, wherein the internal losses of the frequency converter are calculated on the basis of the torque of the motor, the nominal torque of the motor, output frequency of the frequency converter, nominal output frequency of the frequency converter and the losses of the frequency converter in a nominal operating point.

7. A screw compressor drive comprising a screw compressor driven with a frequency converter, wherein the system comprises

    means for pressurising a pressure vessel of the screw compressor with a variable rotational speed of the screw compressor, the rotational speed of the screw compressor having a speed profile in which the rotational speed is changed stepwise such that between stepwise changes the rotational speed of the screw compressor is kept substantially constant for a time period,

    means for repeating the speed profile until the pressure of the pressure vessel reaches a set pressure value,

    means for determining pressure of the pressure vessel, power consumption of the screw compressor drive and mass flow rate during the pressurising when the rotational speed of the screw compressor is kept substantially constant,

    means for calculating energy efficiency of the screw compressor drive as a function of pressure of the pressure vessel and rotational speed of the screw compressor on the on the basis of the determined pressure of the pressure vessel and power consumption of the screw compressor drive.

8. A computer program product comprising a computer program code which, when run on a computer, causes the computer to perform the steps of the method according to any one of claims 1 to 6.

## Patentansprüche

1. Verfahren zum Bestimmen von Betriebseigenschaften eines Schraubenverdichterantriebs, der einen Schraubenverdichter umfasst, der mit einem Frequenzumrichter angetrieben wird, wobei das Verfahren umfasst:

    mit Druck Beaufschlagen eines Druckgefäßes des Schraubenverdichters mit einer variablen Rotationsgeschwindigkeit des Schraubenverdichters, wobei die Rotationsgeschwindigkeit des Schraubenverdichters ein Geschwindigkeitsprofil hat, in welchem die Rotationsgeschwindigkeit schrittweise geändert wird, so dass die Rotationsgeschwindigkeit des Schraubenverdichters zwischen schrittweisen Änderungen für einen Zeitraum im Wesentlichen konstant gehalten wird,
Wiederholen des Geschwindigkeitsprofils bis der Druck des Druckgefäßes einen gesetzten Druckwert erreicht,
Bestimmen von Druck des Druckgefäßes, Leistungsaufnahme des Schraubenverdichterantriebs und Massenstromrate während des mit Druck Beaufschlagens, wenn die Rotationsgeschwindigkeit des Schraubenverdichters im Wesentlichen konstant gehalten wird,
Berechnen einer Energieeffizienz des Schraubenverdichterantriebs als eine Funktion von Druck des Druckgefäßes und Rotationsgeschwindigkeit des Schraubenverdichters auf der Basis des bestimmten Drucks des Druckgefäßes und der Leistungsaufnahme des Schraubenverdichterantriebs.

2. Verfahren nach Anspruch 1, wobei das Verfahren umfasst:

Wählen einer optimalen Rotationsgeschwindigkeit für den Frequenzumrichter als eine Funktion des Drucks des Druckgefäßes.

3. Verfahren nach Anspruch 1 oder Anspruch 2, wobei das Berechnen der Energieeffizienz umfasst:

Wählen mehrerer der Rotationsgeschwindigkeiten,
Berechnen von polynomiellen Anpassungskurven mindestens einer zweiten Ordnung für Druckverhältnis und Energieeffizienz für gewählte Rotationsgeschwindigkeiten,
Wählen mehrerer der Druckverhältnisse,
Berechnen von polynomiellen Anpassungskurven mindestens einer zweiten Ordnung für Rotationsgeschwindigkeit und Energieeffizienz für gewählte Druckverhältnisse, und,
für jedes der gewählten Druckverhältnisse, Bestimmen einer Rotationsgeschwindigkeit, die die beste Energieeffizienz hat, aus den berechneten polynomiellen Anpassungskurven für Rotationsgeschwindigkeit und Energieeffizienz.

4. Verfahren nach Anspruch 3, wobei nach dem Bestimmen der Rotationsgeschwindigkeit, die die beste Energieeffizienz hat, die zum Regeln des Frequenzumrichters verwendete Rotationsgeschwindigkeit auf Basis des Druckverhältnisses gewählt wird.

5. Verfahren nach einem der vorstehenden Ansprüche 1 bis 4, wobei die Leistungsaufnahme des Schraubenverdichters auf Basis der Ausgangsleistung des Frequenzumrichters und inneren Verlusten des Frequenzumrichters abgeschätzt wird.

6. Verfahren nach einem der vorstehenden Ansprüche 1 bis 5, wobei die inneren Verluste des Frequenzumrichters auf der Basis des Drehmoments des Motors, des Nenndrehmoments des Motors, der Ausgangsfrequenz des Frequenzumrichters, der Nennausgangsfrequenz des Frequenzumrichters und der Verluste des Frequenzumrichters in einem Nennbetriebspunkt berechnet werden.

7. Schraubenverdichterantrieb, umfassend einen Schraubenverdichter, der mit einem Frequenzumrichter angetrieben wird, wobei das System umfasst:

Mittel zum mit Druck Beaufschlagen eines Druckgefäßes des Schraubenverdichters mit einer variablen Rotationsgeschwindigkeit des Schraubenverdichters, wobei die Rotationsgeschwindigkeit des Schraubenverdichters ein Geschwindigkeitsprofil hat, in welchem die Rotationsgeschwindigkeit schrittweise geändert wird, so dass die Rotationsgeschwindigkeit des Schraubenverdichters zwischen schrittweisen Änderungen für einen Zeitraum im Wesentlichen konstant gehalten wird,
Mittel zum Wiederholen des Geschwindigkeitsprofils bis der Druck des Druckgefäßes einen gesetzten Druckwert erreicht,
Mittel zum Bestimmen von Druck des Druckgefäßes, Leistungsaufnahme des Schraubenverdichterantriebs und Massenstromrate während des mit Druck Beaufschlagens, wenn die Rotationsgeschwindigkeit des Schraubenverdichters im Wesentlichen konstant gehalten wird,
Mittel zum Berechnen einer Energieeffizienz des Schraubenverdichterantriebs als eine Funktion von Druck des Druckgefäßes und Rotationsgeschwindigkeit des Schraubenverdichters auf der Basis des bestimmten Drucks des Druckgefäßes und der Leistungsaufnahme des Schraubenverdichterantriebs.

8. Computerprogrammprodukt, das einen Computerprogrammcode umfasst, der, wenn er auf einem Computer ausgeführt wird, den Computer dazu bringt, die Schritte des Verfahrens nach einem der Ansprüche 1 bis 6 durchzuführen.

**Revendications**

1. Procédé de détermination de caractéristiques de fonctionnement d'un entraînement de compresseur à vis comprenant un compresseur à vis entraîné par un convertisseur de fréquence, dans lequel le procédé comprend

la pressurisation d'une cuve sous pression du compresseur à vis avec une vitesse de rotation variable du compresseur à vis, la vitesse de rotation du compresseur à vis ayant un profil de vitesse dans lequel la vitesse de rotation est changée par paliers de sorte qu'entre des changements par paliers la vitesse de rotation du compresseur à vis est maintenue sensiblement constante pendant une certaine période de temps,

la répétition du profil de vitesse jusqu'à ce que la pression de la cuve sous pression atteigne une valeur de pression fixée,

la détermination de la pression de la cuve sous pression, de la consommation électrique de l'entraînement de compresseur à vis et du débit massique pendant la pressurisation quand la vitesse de rotation du compresseur à vis est maintenue sensiblement constante,

le calcul du rendement énergétique de l'entraînement de compresseur à vis comme une fonction de la pression de la cuve sous pression et de la vitesse de rotation du compresseur à vis sur la base de la pression déterminée de la cuve sous pression et de la consommation électrique de l'entraînement de compresseur à vis.

2. Procédé selon la revendication 1, dans lequel le procédé comprend

la sélection de la vitesse de rotation optimale pour le convertisseur de fréquence comme une fonction de la pression de la cuve sous pression.

3. Procédé selon la revendication 1 ou la revendication 2, dans lequel le calcul de rendement énergétique comprend

la sélection de multiples vitesses de rotation,

le calcul d'au moins une courbe d'ajustement polynomial de second ordre pour un rapport de pression et un rendement énergétique pour des vitesses de rotation sélectionnées,

la sélection de multiples rapports de pression,

le calcul au moins une courbe d'ajustement polynomial de second ordre pour une vitesse de rotation et un rendement énergétique pour des rapports de pression sélectionnés, et

pour chacun des rapports de pression sélectionnés, la détermination d'une vitesse de rotation ayant le meilleur rendement énergétique à partir des courbes d'ajustement polynomial calculées pour une vitesse de rotation et un rendement énergétique.

4. Procédé selon la revendication 3, dans lequel après la détermination de la vitesse de rotation ayant le meilleur rendement énergétique, la vitesse de rotation utilisée dans la commande du convertisseur de fréquence est sélectionnée sur la base du rapport de pression.

5. Procédé selon l'une quelconque des revendications précédentes 1 à 4, dans lequel la consommation électrique de l'entraînement de compresseur à vis est évaluée sur la base de la puissance de sortie du convertisseur de fréquence et de pertes internes du convertisseur de fréquence.

6. Procédé selon l'une quelconque des revendications précédentes 1 à 5, dans lequel les pertes internes du convertisseur de fréquence sont calculées sur la base du couple du moteur, du couple nominal du moteur, d'une fréquence de sortie du convertisseur de fréquence, d'une fréquence de sortie nominale du convertisseur de fréquence et des pertes du convertisseur de fréquence dans un point de fonctionnement nominal.

7. Entraînement de compresseur à vis comprenant un compresseur à vis entraîné par un convertisseur de fréquence, dans lequel le système comprend

un moyen pour pressuriser une cuve sous pression du compresseur à vis avec une vitesse de rotation variable du compresseur à vis, la vitesse de rotation du compresseur à vis ayant un profil de vitesse dans lequel la vitesse de rotation est changée par paliers de sorte qu'entre des changements par paliers la vitesse de rotation du compresseur à vis est maintenue sensiblement constante pendant une certaine période de temps,

un moyen pour répéter le profil de vitesse jusqu'à ce que la pression de la cuve sous pression atteigne une valeur de pression fixée,

un moyen pour déterminer la pression de la cuve sous pression, la consommation électrique de l'entraînement de compresseur à vis et le débit massique pendant la pressurisation lorsque la vitesse de rotation du compresseur à vis est maintenue sensiblement constante,

un moyen pour calculer le rendement énergétique de l'entraînement de compresseur à vis comme une fonction de la pression de la cuve sous pression et de la vitesse de rotation du compresseur à vis sur la base de la pression déterminée de la cuve sous pression et de la consommation électrique de l'entraînement de compresseur à vis.

8. Produit formant programme informatique comprenant un code de programme informatique qui, lorsqu'il est exécuté sur un ordinateur, amène l'ordinateur à effectuer les étapes du procédé selon l'une quelconque des revendications 1 à 6.

FIG 1

FIG 2

FIG 3

FIG 6

FIG 4

FIG 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005038257 A